# EUROPEAN PATENT SPECIFICATION

(11) **EP 0 453 483 B1**
(45) Date of publication and mention of the grant of the patent: **28.02.1996**
(21) Application number: 90902044.8
(22) Date of filing: 05.01.1990
(51) Int. Cl.: C23G 5/032, C11D 7/20

(54) **NON-TOXIC, NON-FLAMMABLE CLEANER FOR PRINTED BOARD CLEANING**
NICHTTOXISCHE, NICHTENTFLAMMBARE REINIGER ZUM REINIGEN VON GEDRUCKTEN SCHALTUNGEN
AGENT NETTOYANT ININFLAMMABLE ET NON TOXIQUE POUR LE NETTOYAGE DE CARTES DE CIRCUITS IMPRIMES

(30) Priority: 13.01.1989 US 297146
(43) Date of publication of application: 30.10.1991
(73) Proprietor: Martin Marietta Corporation, Bethesda Maryland 20817 (US)
(72) Inventor: TADROS, Maher, Ebeid, Ellicott City, MD 21043 (US); MATZDORF, Craig, Allen, Baltimore, MD 21239 (US); SHAH, Tushar, Kanaiyalal, Baltimore, MD 21228 (US)
(74) Representative: Thomas, Roger Tamlyn
(86) International application number: US9000103
(87) International publication number: WO9008206

(56) References cited:
- WO-A-87/00209
- DE-C- 3 438 399
- US-A- 4 295 845
- US-A- 4 673 524
- Research Disclosure, Volume 275, March 1987, (New York, US), H.L. JACKSON: "Paint Remover free of Chlorinated Solvents", page 176

## Description

### Field of the Invention

The present invention aims to provide non-toxic, environmentally safe compositions for use in cleaning during the fabrication of printed circuit or printed wiring boards. Organic esters are utilized with a non-ionic surfactant to achieve a variety of objectives, among which are the removal of solder flux, oils, waxes, greasy substances, and adhesive tape residues.

### Background of the Invention

In the fabrication of printed wiring boards and/or printed circuit boards, soldering fluxes are first applied to the substrate board material to ensure firm, uniform bonding of the solder. These soldering fluxes fall into two broad categories: rosin and non-rosin, or water soluble, fluxes. The rosin fluxes, which are generally non-corrosive and have a much longer history of use, are still widely used throughout the electronics industry. The water soluble fluxes, which are a more recent development, are being used increasingly in consumer products applications. Because they contain strong acids and/or amine hydrohalides and are thus corrosive, the water soluble soldering fluxes can cause circuit failure if residual traces are not carefully removed.

Even the use of rosin soldering fluxes, however, can lead to premature circuit failure due to decreased board resistance if traces of residual flux are not removed following soldering. While water soluble fluxes can be easily removed with warm, soapy water, the removal of rosin flux from printed wiring boards has traditionally been carried out with the use of chlorinated hydrocarbon solvents such as 1,1,1,-trichlorethane, trichloromonofluoromethane, methylene chloride, trichlorotrifluoroethane, or mixtures or azeotropes of these solvents. One typical disclosure of such azeotropic mixtures is U. S. Patent 3,733,218, of Begun. Such solvents are undesirable, however, because they are toxic. Thus, their use is subject to close scrutiny by the Occupational Safety and Health Administration (OSHA), and stringent containment methods and equipment must be used. Moreover, if released into the environment these solvents are not readily biodegradable and are thus hazardous for long periods of time.

Alkaline cleaning compounds, such as the alkanolamines, usually in the form of monoethanolamine, have been used for rosin flux removal as an alternative to the toxic chlorinated hydrocarbon solvents. These compounds chemically react with rosin flux to form a rosin soap through the process of saponification. Other organic substances such as surfactants or alcohol derivatives may be added to these alkaline cleaning compounds to facilitate the removal of such rosin soap. Unfortunately, these compounds, like the water soluble soldering fluxes, have a tendency to cause corrosion on the surfaces and interfaces of printed wiring boards if they are not completely and rapidly removed during the fabrication process.

In another approach, Bakos et al (U.S. Pat. No. 4,276,186) have used mixtures of N-methyl-2-pyrrolidone and a water miscible alkanolamine to remove solder flux and solder flux residue from integrated circuit modules. These mixtures were also said to be useful for removing various cured synthetic organic polymer compositions such as cured polyimide coating compositions from integrated circuit chip modules.

In another method utilized for cleansing of printed wiring boards, Hayes et al (U.S. Patent 4,640,719), teach the use of terpene compounds, such as limonene or dipentene, in combination with terpene emulsifying surfactants to facilitate removal by rinse water. A major problem with such compositions, however, is their relatively low flash point (120°F = 48.9°C), presenting flammability and safety hazards.

German Patent Application DE-A-34 38 399 discloses a composition for stripping paint from walls comprising a methyl- and/or ethyl- and/or propyl- and/or butyl- ester of succinic acid, glutaric acid and/or adipic acid. Surfactants may be present but are only suggested in combination with other components.

US Patent 4,673,524 discloses a cleaner to remove e.g. auto paint from the hands comprising 25-60 wt.% of a mixture of dimethyl succinate, dimethyl glutarate and dimethyl adipate, 5-15 wt.% of octylphenoxypolyethoxyethanol and 1-3 wt.% nonylphenol ethoxylate, together with various other components.

Research Disclosure, Volume 275, March 1987, (New York, US), page 176, Disclosure No. 27571 discloses a paint remover comprising e.g. 50 wt.% of DBE, and 4 wt.% potassium oleate as surfactant, together with other components. DBE is a product of Du Pont and is a mixture of 15-25% dimethyl succinate, 55-75% dimethyl glutarate and 10-25% dimethyl adipate.

### Summary of the Invention

The present inventors sought to provide compositions and methods for the safe and effective removal of rosin soldering fluxes from printed wiring boards without otherwise adversely affecting the boards, and for the removal of adhesive tape residues from printed wiring boards.

This invention provides cleaning methods and compositions for the removal of rosin solder fluxes and adhesive tape residues during the fabrication of printed circuit or wiring boards. As a result, the possibility of premature circuit failure that might occur in the absence of such cleaning is eliminated or greatly reduced. The cleaning efficacy of the compositions of the invention is such that printed wiring boards thus treated meet the most stringent specifications.

This invention also provides safe and effective compositions for the removal of oils, waxes, greasy substances, fingerprints, etc., from circuit boards and printed circuits, and room temperature cleaning solutions for circuit boards and printed circuits which are effective on baked-on rosin, and safe for soldermasks and epoxy marking inks.

Compositions of the present invention have low toxicity, biodegradability, non-corrosiveness, high flash point and non-flammability, and long shelf life, unlike the chlorinated hydrocarbon solvents and alkaline cleaners that have heretofore been employed for printed wiring boards and printed circuit board cleaning. As a result, the need for costly containment, safety and handling equipment is greatly reduced.

More particularly, the present invention provides printed circuit/wiring board cleaning compositions comprising high boiling esters. These esters, which have the ability to dissolve or complex with and remove rosin solder fluxes, oils, waxes, and greasy substances or adhesive tape residues, may be used by themselves and removed, e.g., with absorbent materials. In the solutions of this invention, the esters are combined with non-ionic surfactants to facilitate removal by water. These surfactants are preferably also used in the residue removal method of the invention.

According to one aspect of the invention, there is provided a cleaning solution consisting of a dialkyl ester selected from dimethyl glutarate, dimethyl succinate, dimethyl adipate, diethyl glutarate, diethyl succinate, diethyl adipate, dipropyl glutarate, dipropyl succinate, dipropyl adipate, and mixtures thereof, and from about 1 to about 30 weight percent non-ionic surfactant.

According to another aspect of the invention, there is provided a method for removing rosin soldering flux or adhesive tape residue from a printed wiring board, said method comprising:
a. contacting said board with a solvent comprising a dialkyl ester selected from dimethyl glutarate, dimethyl succinate, dimethyl adipate, diethyl glutarate, diethyl succinate, diethyl adipate, dipropyl glutarate, dipropyl succinate, dipropyl adipate, and mixtures thereof, and from 0 to about 40 percent by weight non-ionic surfactant;
b. allowing the contact to continue for sufficient time to solubilize the soldering flux or tape residue; and
c. removing the solvent and solubilized soldering flux or tape residue from the board.

Preferred features of the solution and the method are set out in the dependent claims.

### Detailed Description of the Invention

The compositions of the present invention comprise solutions of esters having the capability to dissolve rosin soldering flux and adhesive tape residues that are commonly encountered in the fabrication of printed circuits, surface mounted chips, or wiring boards. Esters which are suitable for this purpose are dialkyl esters selected from dimethyl glutarate, dimethyl succinate, dimethyl adipate, diethyl glutarate, diethyl succinate, diethyl adipate, dipropyl glutarate, dipropyl succinate, dipropyl adipate, and mixtures thereof, with dimethyl adipate being preferred. Included among such esters are dimethyl and diethyl succinates, glutarates, and adipates. Mixtures of two or more of such esters are to be considered within the scope of this invention, but have not been found to be more effective. The esters of the present cleaning compositions have relatively high flash points, e.g., 225-230°F (107.2-110°C), thus providing a safety feature with respect to terpenes having a 120-140°F (48.9-60°C) flash point. Such esters present no fire hazard and are thus non-flammable even at temperatures of about 140°F (60°C), a temperature at which such esters are particularly effective in the removal of baked-on rosin fluxes, which are extremely difficult to remove. Room temperature use is preferred, however, for simplicity, ease, and cost.

These esters could be used alone and removed, after dissolving the rosin flux or adhesive tape residues, by flushing with excess esters or by absorption with paper or cloth. Because they are poorly soluble in water, however, the esters may not be flushed away well with water. Accordingly, the preferred residue removal method of the present invention encompasses forming a solution of such esters with a non-ionic surfactant. The addition of such surfactants facilitates removal of the esters from the printed circuit boards or such by rinsing with water.

Numerous surfactants may be used, including but not limited to the linear or branched chain alcoholic ethoxylates, polysorbate esters, ethoxylated alkylphenols and dialkyl succinate compounds. The ethoxylated alkylphenols contain various alkyl side chains and various numbers of linked ethylene oxide units. The preferred surfactants comprise polyoxyethylated nonylphenols.

The quantity of non-ionic urfactant in the compositions of the present invention may range from about 1 to about 30 percent by weight, with the ester comprising the balance. A preferred ratio of ester to surfactant is from 90/10 to 75/25, with a most preferred ratio of 80/20. Combinations of esters and surfactants as described are true solutions, resulting in extended shelf life for the cleaning compositions of this invention. While such solutions, particularly those having relatively high surfactant concentration, may be diluted with water, dilution is not preferred, in that it reduces the effective strength of the ester constituent.

Compositions of the present invention have non-toxicity, non-flammability, favorable environmental degradability, strong activity at temperatures ranging from about 60.F (15.6°C) to about 150°F (65.6°C) non-conductivity, relatively favorable cost considerations, capability of safe use on soldermasks and epoxy marking inks, and effectiveness against rosin flux, mildly activated rosin, activated rosin, organic fluxes, oils, waxes, greasy substances, fingerprints, and adhesive.

For cleaning circuit boards or printed circuits and the like, application of the compositions of this invention may be by immersion in dip tanks, or by hand or mechanical brushing. Ultrasonic agitation during immersion is not recommended. Also, vapor (degreasing) techniques are inappropriate. Alternatively, they may be applied by any of the commercially available printed wiring board cleaning equipment. Such washers may apply the cleaning solutions by spraying or by rolling contact with wetted roller surfaces. Spray application methods are preferred. The compositions should be in contact with the boards for from about 1 to about 5 minutes. It is permissible to leave the cleaning solution in contact with the boards for longer periods, however, since tests have shown that no etching of the board occurs during contact for up to one week.

Once the solution has had sufficient contact time to loosen or solubilize the flux or other substance to be cleaned, the cleaning compositions are removed. Where the esters are employed without a surfactant, their removal may be accomplished by flushing with a non-toxic, miscible solvent or by absorption into an appropriate material. In the preferred embodiment of the invention, wherein surfactants are present, the boards may be flushed with water, with or without a compatible surfactant, for a short period of time, such as up to about 2 minutes. Optimal rinse periods may be determined by routine experimentation. It is noted that there is no negative effect in the event that rinsing is incomplete and a dried residue of cleaning solution is left on the board, since the cleaning composition of this invention is non-conductive and non-ionic. The cleaned boards are then dried, preferably with forced air. Drying may be expedited by heating the drying air to above about 100°F (37.8°C).

The following illustrative examples are not intended to limit the scope of this invention, but to illustrate its application and use.

### EXAMPLES

To illustrate the cleaning ability of the compositions of the present invention, printed wiring boards having uniform amounts of solder rosin flux residue were prepared and baked at 110°C for 1/2 hour, then cooled to room temperature. Samples of the "standard" printed board were then immersed in various cleaning solutions, until clean, with occasional stirring of the solution.

Various dialkyl esters of succinic, glutaric, and adipic acid were tested, in combination with a non-ionic surfactant in various concentrations It was found that the diethyl esters of adipic acid were preferred, with glutaric acid and succinic acid esters decreasingly effective.

To determine the optimum ratio of ester to surfactant, the following solutions were tested, with the corresponding times required for cleaning. The surfactant utilized in each instance was IGEPAL CO-630, available from GAF Corporation, a nonionic surfactant comprising a nonylphenoxypoly(ethyleneoxy)ethanol, illustrated by the formula 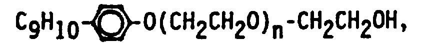 wherein n is 8. The ester utilized for this test was diethyladipate.

| Cleaning Solution | | Time |
|---|---|---|
| Ester | Surfactant | |
| 100% | 0% | 80 Sec. |
| 90 | 10 | 80 |
| 80 | 20 | 120 |
| 70 | 30 | 200 |

A significant drop-off in cleaning performance, as reflected by time, is seen at 70 percent ester/30 percent surfactant. It is concluded that a ratio of 80/20 is the best for cleaning efficiency and rinsing ability.

### Example 1:

Fifteen drops of Kester #185 RMA (rosin, mildly activated) flux were applied with a dropper to a standard 2" x 5" (5.08 cm × 12.7 cm) unetched Pb-Sn epoxy board. The board was then placed in an oven at 110°C for a given time interval and baked.

After the time interval, the board was removed from the oven and let cool to room temperature. Various boards were cleaned with the commercial product Bioact EC-7 terpene based cleaner and a cleaner of the present invention (80% diethyl adipate/20% Igepal CO-630) by immersing in one liter of cleaning solution and swirling the board until clean. The results are as follows:

| Baking Time | Cleaning Time | |
|---|---|---|
| | EC-7 | Invention |
| 0 min. | 40 sec. | 60 sec. |
| 30 min. | 70 sec. | 120 sec. |
| 60 min. | 120 sec. | 150 sec. |

### Example 2:

Fifteen drops of Kester #197 RMA flux were applied with a dropper to a standard 2" x 5" unetched Pb-Sn epoxy board. The board was then placed in an oven at 100°C for 30 minutes and baked.

After 30 minutes, the board was removed from the oven and let cool to room temperature. One board was cleaned with EC-7, another with the cleaner of Example 1, by immersion in 1 liter of solution and swirling the board until clean. The results are as follows:

| Cleaner | Cleaning Time |
|---|---|
| Invention | 195 sec. |
| EC-7 | 135 sec. |

While EC-7 was able to clean the RMA fluxes (#185, 197) more quickly than the invention, the present cleaner was able to clean other types of fluxes [RA (rosin activated) and halide activated] while EC-7 was unable to clean (dissolve) the flux from the boards in a reasonable amount of time, if at all.

### Example 3:

Fifteen drops of Kester #RA 1587 mil. flux were applied with a dropper to a standard 2" x 5" unetched Pb-Sn epoxy board. The board was then placed in an oven at 110°C for 30 minutes and baked.

After 30 minutes, the board was removed from the oven and allowed to dry to room temperature. Boards were cleaned with either EC-7 or the cleaner of Example 1, by immersing in one liter of cleaning solution and swirling the board until clean. The results are as follows:

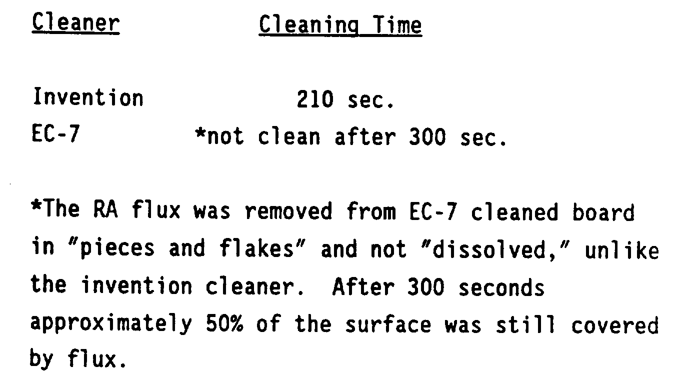

The cleanliness of each board was confirmed by analysis of the ionic contaminants as determinedf by the conductivity of alcohol/water rinsing mixtures (measured by the Omega Meter) and by analysis of the organic residue, determined spectrophotometrically by measuring the UV absorption at 242 nm. of an isopropanol rinse. The Omega Meter result for the cleaner of this invention was 1 µgm Nacl equivalent/in, indicating a high degree of cleanliness. The spectrophotyometric analysis yielded a residue of 9 µgm/in, again indicating a high degree of cleanliness. The corresponding numbers for cleaning with Bioact EC-7 were 2 µgm NaCl equivalent/in for the Omega test and 20 µgm/in for the spectrophotometric test. (in is equivalent to 6.45 cm).

### Example 4:

Fifteen drops of Kester #1588 halide activated flux were applied with a dropper to a standard 2" x 5" unetched Pb-Sn epoxy board. The board was then placed in an oven at 100°C for 30 minutes and baked.

After 30 minutes, the board was removed from the oven and let cool to room temperature. Boards were cleaned with either EC-7 or the cleaner of Example 1 by immersing in one liter of cleaning solution and swirling the board until clean. The results are as follows:

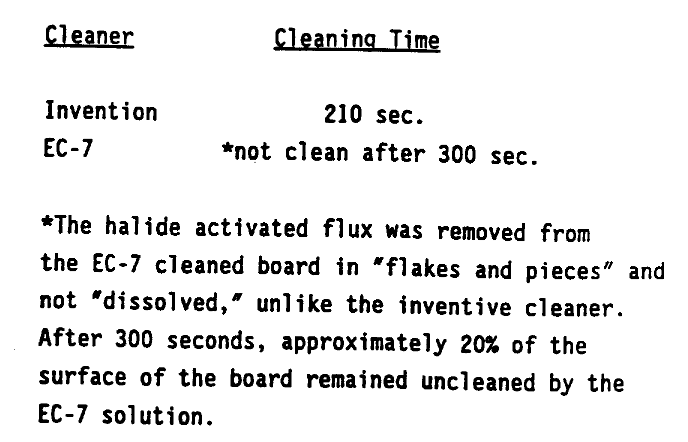

## Claims

1. A cleaning solution consisting of a dialkyl ester selected from dimethyl glutarate, dimethyl succinate, dimethyl adipate, diethyl glutarate, diethyl succinate, diethyl adipate, dipropyl glutarate, dipropyl succinate, dipropyl adipate, and mixtures thereof, and from about 1 to about 30 weight percent non-ionic surfactant.

2. The cleaning solution of claim 1 wherein said ester is selected from dimethyl glutarate, dimethyl succinate, dimethyl adipate, diethyl glutarate, diethyl succinate, diethyl adipate, and mixtures thereof.

3. The cleaning solution of claim 2 wherein said ester is dimethyl adipate.

4. The cleaning solution of claim 1, 2 or 3 wherein said surfactant comprises from about 10 to 25 percent by weight.

5. The cleaning solution of claim 4 wherein said surfactant comprises about 20 percent by weight.

6. The cleaning solution of any one of claims 1-5 wherein said surfactant is selected from linear or branched chain alcoholic ethoxylates, polysorbate esters, dialkyl succinate compounds, and ethoxylated alkylphenols.

7. The cleaning solution of claim 6 wherein said surfactant is nonylphenoxypoly(ethyleneoxy)ethanol.

8. A method for removing rosin soldering flux or adhesive tape residue from a printed wiring board, said method comprising:
a. contacting said board with a solvent comprising a dialkyl ester selected from dimethyl glutarate, dimethyl succinate, dimethyl adipate, diethyl glutarate, diethyl succinate, diethyl adipate, dipropyl glutarate, dipropyl succinate, dipropyl adipate, and mixtures thereof, and from 0 to about 40 percent by weight non-ionic surfactant;
b. allowing the contact to continue for sufficient time to solubilize the soldering flux or tape residue; and
c. removing the solvent and solubilized soldering flux or tape residue from the board.

9. The method of claim 8 wherein the ester is selected from dimethyl glutarate, dimethyl succinate, dimethyl adipate, diethyl glutarate, diethyl succinate, diethyl adipate, and mixtures thereof.

10. The method of claim 9 wherein said ester is dimethyl adipate.

11. The method of claim 8, 9 or 10 wherein the contact is carried out at a temperature of from about room temperature to about 150°F (65.6°C).

12. The method of claim 8, 9, 10 or 11 wherein the surfactant is selected from linear or branched chain alcoholic ethoxylates, polysorbate esters, dialkyl succinate compounds, and ethoxylated alkylphenols.

13. The method of claim 12 wherein the surfactant is a nonylphenoxypoly(ethyleneoxy)ethanol.

14. The method of any one of claims 8-13 wherein the ratio of ester to surfactant is from about 99/1 to about 70/30.

15. The method of claim 14 wherein the ratio of ester to surfactant is from about 90/10 to about 75/25.

16. The method of claim 15 wherein the ratio of ester to surfactant is about 80/20.

17. The method of any one of claims 8-16 wherein the solution and solubilized soldering flux or tape residue are removed by rinsing with water.

## Patentansprüche

1. Reinigungslösung bestehend aus einem Dialkylester, der unter Dimethylglutarat, Dimethylsuccinat, Dimethyladipat, Diethylglutarat, Diethylsuccinat, Diethyladipat, Dipropylglutarat, Dipropylsuccinat, Dipropyladipat und Gemischen hiervon ausgewählt ist, und etwa 1 bis etwa 30 Gew.-% nichtionischem oberflächenaktivem Mittel.

2. Reinigungslösung nach Anspruch 1, worin der Ester unter Dimethylglutarat, Dimethylsuccinat, Dimethyladipat, Diethylglutarat, Diethylsuccinat, Diethyladipat und Gemischen hiervon ausgewählt ist.

3. Reinigungslösung nach Anspruch 2, worin der Ester Dimethyladipat ist.

4. Reinigungslösung nach Anspruch 1, 2 oder 3, worin das oberflächenaktive Mittel etwa 10 bis 25 Gew.-% umfaßt.

5. Reinigungslösung nach Anspruch 4, worin das oberflächenaktive Mittel etwa 20 Gew.-% umfaßt.

6. Reinigungslösung nach einem der Ansprüche 1 bis 5, worin das oberflächenaktive Mittel unter linearen oder verzweigtkettigen Alkoholethoxylaten, Polysorbatestern, Dialkylsuccinatverbindungen und ethoxylierten Alkylphenolen ausgewählt ist.

7. Reinigungslösung nach Anspruch 6, worin das oberflächenaktive Mittel Nonylphenoxypoly-(ethylenoxy)-ethanol ist.

8. Verfahren zur Entfernung von Kolophoniumlötflußmittel oder Klebstreifenrückstand von einer gedruckten Leitungsplatte, indem man
a) die Platte mit einem Lösungsmittel in Kontakt bringt, das einen Dialkylester, welcher unter Dimethylglutarat, Dimethylsuccinat, Dimethyladipat, Diethylglutarat, Diethylsuccinat, Diethyladipat, Dipropylglutarat, Dipropylsuccinat, Dipropyladipat und Gemischen hiervon ausgewählt ist, und 0 bis etwa 40 Gew.-% nichtionisches oberflächenaktives Mittel umfaßt,
b) den Kontakt ausreichend lange aufrechterhält, um das Lötflußmittel oder den Klebstreifenrückstand löslich zu machen, und
c) das Lösungsmittel und löslichgemachtes Lötflußmittel oder löslichgemachten Klebstreifenrückstand von der Platte entfernt.

9. Verfahren nach Anspruch 8, bei dem der Ester unter Dimethylglutarat, Dimethylsuccinat, Dimethyladipat, Diethylglutarat, Diethylsuccinat, Diethyladipat und Gemischen hiervon ausgewählt ist.

10. Verfahren nach Anspruch 9, bei dem der Ester Dimethyladipat ist.

11. Verfahren nach Anspruch 8, 9 oder 10, bei dem der Kontakt bei einer Temperatur von etwa Raumtemperatur bis etwa 150 °F (65,6 °C) durchgeführt wird.

12. Verfahren nach Anspruch 8, 9, 10 oder 11, bei dem das oberflächenaktive Mittel unter linearen oder verzweigtkettigen Alkohholethoxylaten, Polysorbatestern, Dialkylsuccinatverbindungen und ethoxylierten Alkylphenolen ausgewählt wird.

13. Verfahren nach Anspruch 12, bei dem das oberflächenaktive Mittel ein Nonylphenoxypoly-(ethylenoxy)-ethanol ist.

14. Verfahren nach einem der Ansprüche 8 bis 13, bei dem das Verhältnis von Ester zu oberflächenaktivem Mittel etwa 99 : 1 bis etwa 70 : 30 ist.

15. Verfahren nach Anspruch 14, bei dem das Verhältnis von Ester zu oberflächenaktivem Mittel etwa 90 : 10 bis etwa 75 : 25 ist.

16. Verfahren nach Anspruch 15, bei dem das Verhältnis von Ester zu oberflächenaktivem Mittel etwa 80 : 20 ist.

17. Verfahren nach einem der Ansprüche 8 bis 16, bei dem die Lösung und löslichgemachtes Lötflußmittel oder löslichgemachter Klebstreifenrückstand durch Spülen mit Wasser entfernt werden.

## Revendications

1. Solution nettoyante, constituée d'un ester dialkylique choisi parmi le glutarate de diméthyle, le succinate de diméthyle, l'adipate de diméthyle, le glutarate de diéthyle, le succinate de diéthyle, l'adipate de diéthyle, le glutarate de dipropyle, le succinate de dipropyle, l'adipate de dipropyle et leurs mélanges, et d'environ 1 à environ 30 % en poids d'un tensioactif non-ionique.

2. Solution nettoyante selon la revendication 1, dans laquelle ledit ester est choisi parmi le glutarate de diméthyle, le succinate de diméthyle, l'adipate de diméthyle, le glutarate de diéthyle, le succinate de diéthyle, l'adipate de diéthyle et leurs mélanges.

3. Solution nettoyante selon la revendication 2, dans laquelle ledit ester est l'adipate de diméthyle.

4. Solution nettoyante selon la revendication 1, 2 ou 3, dans laquelle ledit tensioactif compte pour environ 10 à 25 pourcent en poids.

5. Solution nettoyante selon la revendication 4, dans laquelle ledit tensioactif compte pour environ 20 pourcent en poids.

6. Solution nettoyante selon l'une quelconque des revendications 1 à 5, dans laquelle ledit tensioactif est choisi parmi les produits d'éthoxylation d'alcools à chaîne droite ou linéaire, les polysorbates, les alkylsuccinates et les alkylphénols éthoxylés.

7. Solution nettoyante selon la revendication 6, dans laquelle ledit tensioactif est le nonylphénoxyéthanol polyéthoxylé.

8. Procédé pour éliminer d'une carte imprimée le fondant de soudage à la colophane ou les résidus de rubans adhésifs, ledit procédé consistant :
a. à mettre en contact ladite carte avec un solvant comprenant un ester dialkylique choisi parmi le glutarate de diméthyle, le succinate de diméthyle, l'adipate de diméthyle, le glutarate de diéthyle, le succinate de diéthyle, l'adipate de diéthyle, le glutarate de dipropyle, le succinate de dipropyle, l'adipate de dipropyle et leurs mélanges, et de 0 à 40 % en poids d'un tensioactif non-ionique ;
b. à laisser le contact se poursuivre pendant un temps suffisant pour solubiliser le fondant de soudage ou le résidu de ruban adhésif ; et
c. à éliminer de la carte le solvant et le fondant de soudage ou le résidu de ruban adhésif solubilisé.

9. Procédé selon la revendication 8, dans lequel l'ester est choisi parmi le glutarate de diméthyle, le succinate de diméthyle, l'adipate de diméthyle, le glutarate de diéthyle, le succinate de diéthyle, l'adipate de diéthyle et leurs mélanges.

10. Procédé selon la revendication 9, dans lequel ledit ester est l'adipate de diméthyle.

11. Procédé selon la revendication 8, 9 ou 10, dans lequel le contact est mis en oeuvre à une température comprise entre environ la température ambiante et environ 65,6°C (150°F).

12. Procédé selon la revendication 8, 9, 10 ou 11, dans lequel le tensioactif est choisi parmi les produits d'éthoxylation d'alcools à chaîne droite ou ramifiée, les polysorbates, les dialkylsuccinates et les alkylphénols éthoxylés.

13. Procédé selon la revendication 12, dans lequel le tensioactif est un nonylphénoxyéthanol polyéthoxylé.

14. Procédé selon l'une quelconque des revendications 8 à 13, dans lequel le rapport de l'ester au tensioactif est d'environ 99/1 à environ 70/30.

15. Procédé selon la revendication 14, dans lequel le rapport de l'ester au tensioactif est d'environ 90/10 à environ 75/25.

16. Procédé selon la revendication 15, dans lequel le rapport de l'ester au tensioactif est d'environ 80/20.

17. Procédé selon l'une quelconque des revendications 8 à 16, dans lequel la solution et le fondant de soudage ou le résidu de ruban adhésif solubilisé sont enlevés par rinçage à l'eau.
